(19) **Europäisches Patentamt / European Patent Office / Office européen des brevets**

(11) **EP 3 551 976 B1**

(12) **FASCICULE DE BREVET EUROPEEN**

(45) Date de publication et mention
de la délivrance du brevet:
**03.05.2023 Bulletin 2023/18**

(21) Numéro de dépôt: **17816990.0**

(22) Date de dépôt: **05.12.2017**

(51) Classification Internationale des Brevets (IPC):
**G01J 5/20** *(2006.01)*   **G01J 5/02** *(2022.01)*
**G01J 5/08** *(2022.01)*   **H01L 27/146** *(2006.01)*

(52) Classification Coopérative des Brevets (CPC):
**H01L 27/14649; G01J 5/0225; G01J 5/20;
H01L 27/14629;** H01L 27/14621

(86) Numéro de dépôt international:
**PCT/FR2017/053402**

(87) Numéro de publication internationale:
**WO 2018/104653 (14.06.2018 Gazette 2018/24)**

(54) **CAPTEUR D'IMAGE INFRAROUGE**

INFRAROTBILDSENSOR

INFRARED IMAGE SENSOR

(84) Etats contractants désignés:
**AL AT BE BG CH CY CZ DE DK EE ES FI FR GB
GR HR HU IE IS IT LI LT LU LV MC MK MT NL NO
PL PT RO RS SE SI SK SM TR**

(30) Priorité: **07.12.2016 FR 1662079**

(43) Date de publication de la demande:
**16.10.2019 Bulletin 2019/42**

(73) Titulaire: **LYNRED
91120 Palaiseau (FR)**

(72) Inventeurs:
• **BOUDOU, Nicolas
38100 Grenoble (FR)**
• **GORECKI, Alexia
38000 Grenoble (FR)**

(74) Mandataire: **Cabinet Beaumont
4, Place Robert Schuman
B.P. 1529
38025 Grenoble Cedex 1 (FR)**

(56) Documents cités:
**EP-A1- 2 602 598      JP-A- H11 326 039
US-A- 5 868 496      US-A1- 2014 054 462**

• **Anonymous: "Infrarouge", Wikipédia , 22
septembre 2016 (2016-09-22), XP055409425,
Extrait de l'Internet:
URL:https://fr.wikipedia.org/w/index.php?t
itle=Infrarouge&oldid=129847228 [extrait le
2017-09-25]**

**Description**

Domaine

La présente demande concerne un capteur d'image infrarouge.

Exposé de l'art antérieur

On utilise un dispositif d'imagerie infrarouge, tel qu'une caméra infrarouge dans le cas général, pour former des images en relation avec un flux infrarouge issu d'une scène observée, c'est-à-dire avec les températures des éléments de cette scène. Pour les applications thermographiques, il est question de fournir une estimation de ces températures. La caméra comprend en particulier une optique de focalisation adaptée et un capteur d'image infrarouge placé au foyer de cette optique.

Le document JP 11-326039 A décrit un capteur d'image infrarouge bolométrique comprenant des pixels ayant des réponses spectrales différentes.

Le document US 5,868,496 décrit un dispositif et un procédé d'estimation de température et d'émissivité.

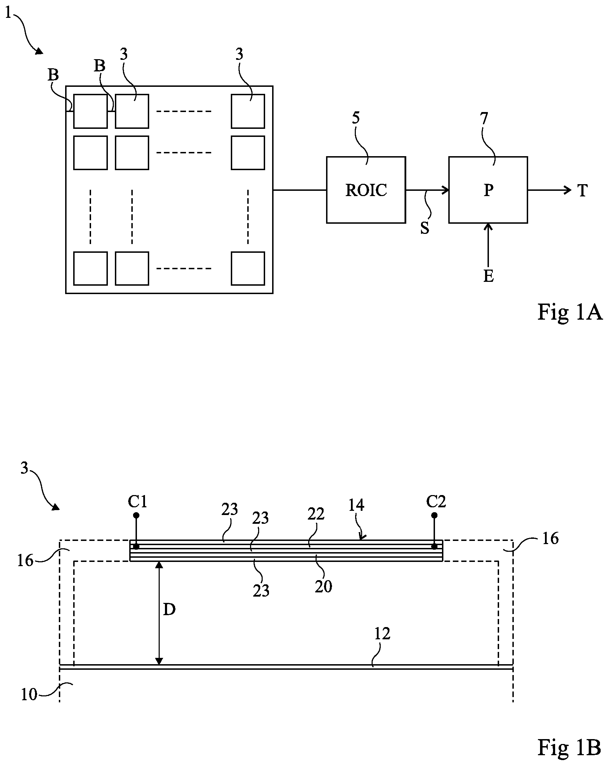

La figure 1A représente un tel capteur 1 d'image infrarouge. Le capteur 1 comprend un ensemble de pixels 3 disposés en matrice et pouvant fonctionner à température ambiante. La matrice de pixels 3 est reliée à un circuit de lecture 5, appelé en anglais "Read Out Integrated Circuit" (ROIC), prévu pour produire des signaux électroniques S en relation avec le flux radiatif atteignant chaque pixel. Le dispositif comprend une unité de traitement 7 (P) capable d'exploiter ces signaux S et d'en déduire des estimations des températures T des éléments de la scène. L'unité de traitement 7 comporte des moyens de calcul et de la mémoire et est préférentiellement disposée à proximité immédiate du capteur 1. Cette unité peut aussi être un ordinateur situé à distance.

La figure 1B est une vue en coupe d'un exemple de pixel 3 du capteur 1 selon un plan B-B représenté en figure 1A. Le capteur 1 est de type bolométrique, capable de fonctionner à température ambiante. Le pixel 3 comprend, au-dessus d'un substrat 10 recouvert d'un réflecteur métallique 12, une membrane bolométrique plane 14 suspendue par des bras 16. Les bras 16 présentent une résistance thermique de valeur élevée, uniforme pour tous les pixels du capteur, entre la membrane 14 et le substrat 10. La membrane bolométrique comprend dans cet exemple une couche absorbante métallique 20 et une couche de mesure 22. Chacune des couches 20 et 22 est disposée entre des couches diélectriques 23 de support et de séparation. La couche de mesure 22 est constituée d'un matériau dont la résistance électrique varie en fonction de la température et est munie à ses extrémités de contacts C1 et C2. L'épaisseur de l'empilement des couches formant la membrane 14 est typiquement de l'ordre de 100 nm, ou peut être plus importante, par exemple jusqu'à de l'ordre de 1 $\mu$m.

Chaque élément de la scène émet un rayonnement infrarouge selon un spectre d'émission correspondant à la loi de Planck du rayonnement du corps noir pondérée par l'émissivité de l'élément considéré. Les longueurs d'onde du rayonnement reçu au niveau du plan focal sont essentiellement comprises dans une plage qui s'étend entre 7 et 14 $\mu$m. Dans le cas général, un système d'observation thermique est en effet conçu pour procurer une sensibilité maximale entre 7 et 14 $\mu$m et une sensibilité négligeable en dehors de cette plage qui correspond à la plage d'émission maximale d'un corps noir à température ambiante. Ce rayonnement est absorbé par la membrane d'un pixel en vis-à-vis de l'élément de scène. Pour cela, dans chaque pixel 3, la distance D entre la membrane bolométrique et le réflecteur est sensiblement de 2,5 $\mu$m, c'est-à-dire environ le quart de la longueur d'onde centrale de la plage de longueurs d'onde concernée. Du fait de la résistance thermique des bras 16, le rayonnement absorbé induit un échauffement de la membrane proportionnel à la puissance du rayonnement reçu. La température de la membrane est ainsi fonction de la température de l'élément de scène. Les signaux S, à partir desquels la température de la membrane est déterminée, sont produits par le circuit de lecture 5 à partir d'une mesure de la résistance électrique de la couche 22 entre les contacts C1 et C2.

La température de la membrane dépend à la fois de la température de l'élément de scène et de l'émissivité de cet élément. Afin de déterminer la température T de l'élément de scène, l'unité de traitement 7 doit tenir compte de l'émissivité E de cet élément. En d'autres termes, l'imprécision sur la valeur de l'émissivité, qui peut varier notablement d'un élément de la scène à un autre, par exemple selon la matière ou la texture de la surface émettrice, se reporte sur la valeur de la température déterminée. Il en résulte un manque de précision de la température ainsi déterminée. En outre, fournir l'émissivité d'éléments de scène à l'unité de traitement pose divers problèmes pratiques d'utilisation et de mise en oeuvre.

Résumé

Un mode de réalisation prévoit un capteur d'image infrarouge palliant tout ou partie des inconvénients décrits ci-dessus.

Ainsi, l'invention prévoit un capteur d'image infrarouge selon la revendication 1, ledit capteur comprenant sur un support une pluralité de premiers pixels et une pluralité de deuxièmes pixels destinés à capter un rayonnement infrarouge émis par un élément d'une scène, chaque pixel comprenant une membrane bolométrique suspendue au-dessus d'un réflecteur recouvrant le support, le réflecteur de chaque premier pixel étant recouvert d'une première couche diélectrique, et le réflecteur de chaque deuxième pixel étant recouvert d'une deuxième couche diélectrique différente de la première couche diélectrique par ses propriétés optiques;

un circuit de lecture (36) de premières valeurs (V1, V2) représentatives des températures des membranes bolométriques (14) de premier et deuxième pixels voisins ; et

- une unité de traitement (38) adaptée a déterminer l'émissivité de l'élément de la scène à partir des premières valeurs (V1, V2), l'unité de traitement étant configurée pour produire des valeurs estimées de température (Ti, $T_E$) et d'émissivité (Ei, $E_E$) correspondant à un minimum d'une valeur d'erreur représentative de différences, les différences comprenant :

une première différence entre la première valeur (V1) lue du premier pixel et une deuxième valeur ($V1_{TH}$) représentative de la température qu'aurait la membrane bolométrique du premier pixel d'après un modèle théorique si la température et l'émissivité de l'élément de scène avaient les valeurs estimées ; et

une deuxième différence entre la première valeur (V2) lue du deuxième pixel et une autre deuxième valeur ($V2_{TH}$) représentative de la température qu'aurait la membrane bolométrique du deuxième pixel d'après le modèle théorique si la température et l'émissivité de l'élément de scène avaient les valeurs estimées.

Selon un mode de réalisation, la différence de propriété optique résulte d'au moins une caractéristique dans la liste suivante : les première et deuxième couches diélectriques ont des épaisseurs différentes ; les première et deuxième couches diélectriques sont en des matériaux d'indices de réfraction différents ; la première couche présente un motif en réseau et la deuxième couche est pleine ; et les première et deuxième couches présentent des motifs en réseaux différents dans la première couche et dans la deuxième couche.

Selon un mode de réalisation, le capteur comprend une matrice de couples de pixels de l'un des premiers pixels et de l'un des deuxièmes pixels.

Selon un mode de réalisation, les membranes bolométriques de tous lesdits pixels sont structurellement identiques et les réflecteurs de tous lesdits pixels sont structurellement identiques.

Selon un mode de réalisation, les premiers et deuxièmes pixels sont disposés en damier.

Selon un mode de réalisation, le capteur est destiné à capter des rayonnements dont les longueurs d'onde sont situées dans une plage de longueurs d'onde, la distance dans chaque pixel entre la membrane et ladite couche diélectrique étant égale au quart d'une longueur d'onde située dans une partie centrale de ladite plage.

Selon un mode de réalisation, ladite plage s'étend entre 7 et 14 $\mu$m et ladite distance est comprise entre 2 et 3 $\mu$m.

Selon un mode de réalisation, pour la première couche diélectrique, le produit de l'épaisseur par l'indice de réfraction est égal au quart d'une première longueur d'onde, et, pour la deuxième couche diélectrique, le produit de l'épaisseur par l'indice de réfraction est égal au quart d'une deuxième longueur d'onde, les première et deuxième longueurs d'onde étant situées dans ladite plage et étant différentes l'une de l'autre.

Selon un mode de réalisation, les première et deuxième couches diélectriques sont en un matériau identique et ont une même épaisseur, la distance séparant la membrane bolométrique de la couche diélectrique étant identique dans les premier et deuxième pixels, chaque deuxième couche diélectrique présentant un motif en réseau formé d'éléments ayant, dans des directions parallèles au plan de la couche, des dimensions inférieures au tiers de la plus petite longueur d'onde de ladite plage.

Selon un mode de réalisation, les première et deuxième couches diélectriques sont en silicium amorphe.

Selon un mode de réalisation, l'unité de traitement est adaptée à mettre en oeuvre les étapes suivantes : a) définir un couple initial de valeurs estimées de température et d'émissivité ; b) calculer des deuxièmes valeurs représentatives des températures qu'auraient les membranes bolométriques desdits pixels voisins d'après un modèle théorique si la température et l'émissivité de l'élément de scène étaient les valeurs estimées de température et d'émissivité ; c) calculer les différences entre les premières valeurs et les deuxièmes valeurs correspondantes ; d) produire des nouvelles valeurs estimées de température et d'émissivité sur la base desdites différences ; et e) répéter les étapes b), c) et d) sur la base des nouvelles valeurs estimées de façon à réduire lesdites différences.

Selon un mode de réalisation, le capteur comprend en outre une pluralité de troisièmes pixels destinés à capter un rayonnement infrarouge émis par la scène extérieure, chaque troisième pixel comprenant une membrane bolométrique suspendue au-dessus d'un réflecteur recouvrant le support, le réflecteur n'étant pas recouvert d'une couche diélectrique.

Un autre mode de réalisation prévoit un pixel comprenant une membrane bolométrique suspendue au-dessus d'un réflecteur recouvrant un support, le réflecteur étant recouvert d'une couche diélectrique présentant un motif en réseau.

Un autre mode de réalisation prévoit une matrice de pixels ci-dessus dont lesdits motifs en réseaux sont identiques.

Brève description des dessins

Ces caractéristiques et avantages, ainsi que d'autres, seront exposés en détail dans la description suivante de modes de réalisation particuliers faite à titre non limitatif en relation avec les figures jointes parmi lesquelles :

la figure 1A illustre schématiquement un capteur d'image infrarouge ;
la figure 1B est une vue schématique en coupe d'un pixel du capteur de la figure 1A ;
la figure 2A illustre schématiquement un mode de réalisation d'un capteur d'image infrarouge ;
la figure 2B est une vue schématique en coupe de deux pixels de la figure 2A ;
la figure 3 représente des courbes d'absorption de rayonnement infrarouge pour divers types de pixels, en fonction de la longueur d'onde du rayonnement ;
la figure 4 illustre un procédé d'obtention d'une valeur de température ;
la figure 5A est une vue schématique en coupe de deux pixels d'un mode de réalisation d'un capteur d'image infrarouge ; et
la figure 5B est une vue de dessus en coupe schématique d'un pixel de la figure 5A.

Description détaillée

De mêmes éléments ont été désignés par de mêmes références dans les différentes figures et, de plus, les diverses figures ne sont pas tracées à l'échelle. Par souci de clarté, seuls les éléments utiles à la compréhension des modes de réalisation décrits ont été représentés et sont détaillés. En particulier, des bras de support de membranes ne sont pas représentés en détail.

Dans la description qui suit, lorsque l'on fait référence à des qualificatifs de position relative, tels que les termes "dessus", "supérieur", "inférieur", etc., ou d'orientation, tel que le terme "latéral", il est fait référence à l'orientation de l'élément concerné dans les figures concernées. Sauf précision contraire, l'expression "sensiblement" signifie à 10 % près, de préférence à 5 % près.

Dans la description qui suit, le terme "indice de réfraction" désigne la partie réelle d'un indice de réfraction dont la partie imaginaire est négligeable.

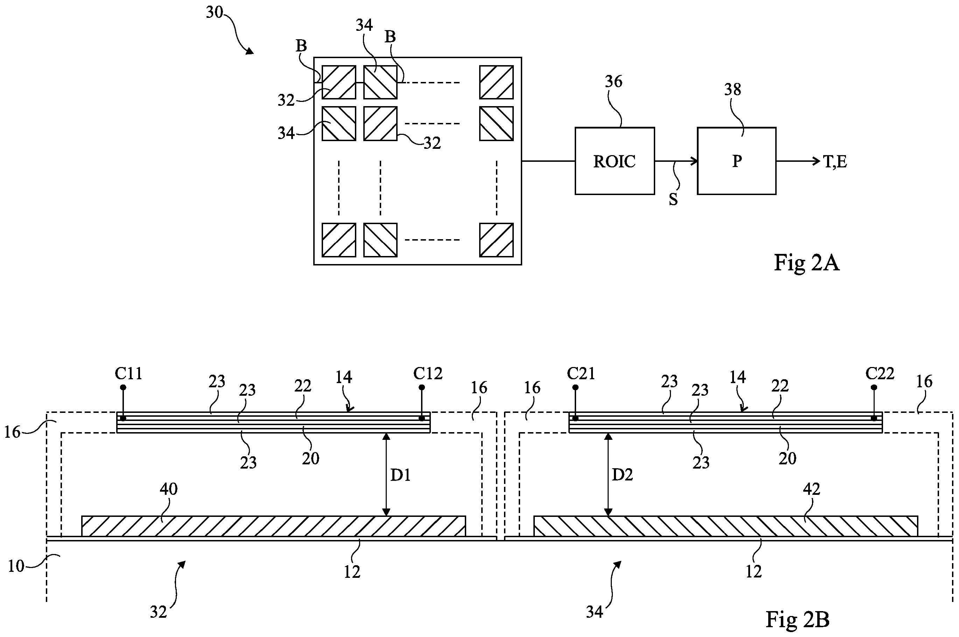

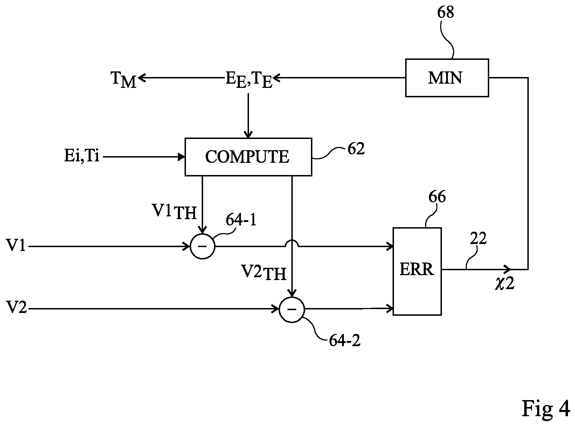

La figure 2A illustre un mode de réalisation d'un capteur 30 d'image infrarouge. Le capteur 30 comprend une matrice de couples de pixels 32, 34, respectivement d'un premier type et d'un deuxième type. Les pixels 32 et 34 d'un couple sont juxtaposés, les pixels 32 et 34 de la matrice étant par exemple disposés en damier. Le capteur 30 comprend un circuit de lecture 36 (ROIC) relié aux pixels 32 et 34. Le circuit de lecture 36 est prévu pour produire des signaux S représentatifs des températures des membranes bolométriques et exploités par une unité de traitement 38 (P). L'unité de traitement 38 est prévue pour déterminer des températures T d'éléments d'une scène en mettant en oeuvre un procédé dont un exemple sera décrit ci-après en relation avec la figure 4. L'unité de traitement 38 est prévue pour déterminer des émissivités E d'éléments de scène.

La figure 2B est une vue en coupe de pixels 32 et 34 voisins, selon le plan B-B de la figure 2A.

Chacun des pixels 32 et 34 comprend les éléments du pixel 3 de la figure 1B. A titre d'exemple, ces éléments sont structurellement identiques pour les deux types de pixel, c'est à dire que ces éléments sont en des matériaux identiques disposés selon des configurations identiques de dimensions sensiblement identiques. Ainsi, chacun des pixels 32 et 34 comprend une membrane bolométrique 14 comportant une couche d'absorption 20, par exemple en nitrure de titane, et une couche de mesure 22, par exemple en silicium amorphe, chacune des couches 20, 22 étant disposée entre des couches diélectriques 23, par exemple en nitrure ou oxynitrure de silicium. La couche de mesure 22 de chaque pixel 32 est munie de contacts C11 et C12 et la couche de mesure 22 de chaque pixel 34 est munie de contacts C21 et C22. La membrane bolométrique 14 de chaque pixel est suspendue par des bras 16 au-dessus d'un réflecteur métallique 12 recouvrant un support 10, par exemple un substrat semiconducteur.

A titre d'exemple, le circuit de lecture 36 est formé dans et sur le substrat 10 et chaque pixel est relié au circuit de lecture 36 par des connexions électriques situées dans les bras 16. A titre d'exemple, les pixels sont répétés latéralement à un pas compris entre 10 et 40 $\mu$m, ce pas correspondant sensiblement aux dimensions latérales d'un pixel.

A la différence des pixels 3 des figures 1A et 1B, chacun des pixels 32 et 34 comprend une couche diélectrique, respectivement 40 et 42, disposée sur le réflecteur 12. Les couches diélectriques 40 et 42 des pixels 32 et 34 sont différentes par leurs propriétés optiques. Dans l'exemple illustré, les couches diélectriques 40 et 42 ont des mêmes épaisseurs mais sont en des matériaux d'indices de réfraction différents. Ces couches peuvent aussi être en un même matériau et avoir des épaisseurs différentes. A titre d'exemple, le matériau des couches 40 et 42 peut être du silicium, par exemple du silicium amorphe, du germanium, ou peut contenir à la fois du silicium et du germanium.

Le capteur 30 est par exemple destiné à capter des rayonnements infrarouges de longueurs d'onde inférieures à 25 $\mu$m, par exemple inférieures à 20 $\mu$m, et de fréquences supérieures à 12 THz, par exemple supérieures à 15 THz.

A titre d'exemple, le capteur 30 est destiné à capter des rayonnements infrarouges situés dans une plage qui s'étend entre 7 et 14 $\mu$m. Dans chacun des pixels 32 et 34, la distance, respectivement D1 et D2, séparant la face inférieure de la membrane bolométrique 14 de la face supérieure de la couche diélectrique est égale au quart d'une longueur d'onde située dans une partie centrale de cette plage, correspondant pour la plage qui s'étend de 7 à 14 $\mu$m à des distances D1 et D2 comprises par exemple entre 2 et 3 $\mu$m. Les distances D1 et D2 peuvent ainsi être différentes et comprises chacune entre 2 et 3 $\mu$m. A titre d'exemple, les distances D1 et D2 sont sensiblement égales, par exemple sont de 2,5 $\mu$m c'est-à-dire alors identiques à la distance D séparant, dans le pixel 3 de la figure 1B, la membrane bolométrique du réflecteur.

La présence des couches diélectriques 40, 42 différentes dans les pixels 32 et 34 confère à ces pixels des propriétés d'absorption différentes.

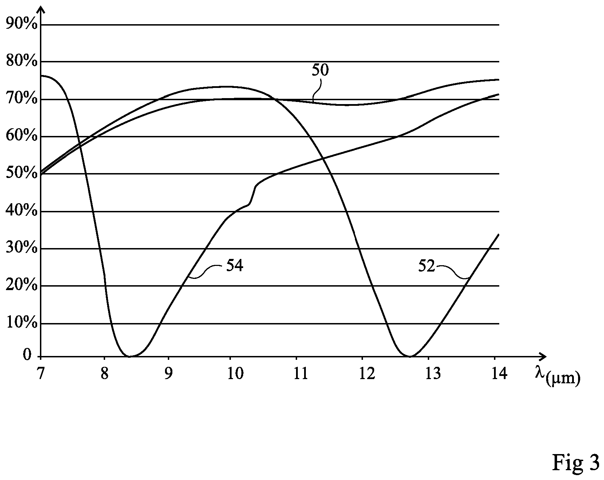

La figure 3 représente un exemple de spectres d'absorption de rayonnement infrarouge par la membrane 14 d'un pixel 3 de la figure 1B et par les membranes 14 de pixels 32 et 34 de la figure 2B en fonction de la longueur d'onde $\lambda$ du rayonnement. Les courbes 50, 52 et 54 correspondent respectivement aux pixels 3, 32 et 34, et ont été obtenues par simulation numérique.

Dans l'exemple de la figure 3, les épaisseurs et les indices de réfraction des couches diélectriques 40 et 42 sont choisis pour que des interférences destructives apparaissent au niveau de la membrane 14 pour des longueurs d'onde proches respectivement de 12,5 $\mu$m (courbe 52) et de 8,5 $\mu$m (courbe 54). Ces conditions particulières d'interférences réduisent fortement l'absorption par la membrane pour ces longueurs d'onde, l'absorption étant quasiment nulle dans l'exemple représenté. Dans cet exemple, d'une part, la couche diélectrique 40 du pixel 32 a une épaisseur de 1 $\mu$m et un indice de réfraction de 3,5, proche de celui du silicium amorphe, et, d'autre part, la couche diélectrique 42 du pixel 34 a une épaisseur de 1 $\mu$m et un indice de réfraction de 2,15. Dans chaque pixel 32, 34, on obtient une réduction de l'absorption des rayonnements dont les longueurs d'onde sont proches d'une valeur égale à quatre fois le produit de l'indice de réfraction de la couche diélectrique, respectivement 40, 42, par l'épaisseur de cette couche. Cette valeur est différente pour les pixels 32 et 34 et est comprise dans la plage qui s'étend entre 7 et 14 $\mu$m. De ce fait, les propriétés d'absorption des pixels 32 et 34 sont différentes dans cette plage. Les couches diélectriques 40 et 42 peuvent ainsi avoir des épaisseurs comprises entre 0,5 et 3 $\mu$m et des indices de réfraction compris entre 1,5 et 4.

Lorsque le pixel 3 de la figure 1B reçoit d'un élément de scène un rayonnement ayant des longueurs d'onde comprises entre 7 et 14 $\mu$m, la température de la membrane 14 du pixel 3 résulte de l'ensemble du rayonnement, du fait que ce rayonnement est absorbé à plus de 50 % pour toutes les longueurs d'onde concernées. Au contraire, lorsque ce rayonnement est reçu par les pixels 32 et 34, la température de la membrane 14 du pixel 32 résulte principalement de la partie du rayonnement dont les longueurs d'onde sont inférieures à environ 11 $\mu$m, et la température de la membrane 14 du pixel 34 résulte principalement de la partie du rayonnement dont les longueurs d'onde sont supérieures à environ 11 $\mu$m.

Pour deux pixels 32 et 34 voisins recevant un rayonnement infrarouge, le circuit de lecture 36 détermine deux valeurs V1 et V2 de signaux représentatifs des températures respectives des membranes bolométriques des deux pixels, en mesurant les résistances des couches de mesure 22 respectivement entre les contacts C11 et C12 et entre les contacts C21 et C22. Dans le cas où le rayonnement reçu provient d'un même élément de scène, ou d'éléments de scènes dont les émissivités et températures sont indiscernables, les deux valeurs V1 et V2 permettent à l'unité de traitement 38 de déterminer simultanément la température et l'émissivité de l'élément de scène, du fait des propriétés d'absorption différentes des pixels 32 et 34, comme nous le verrons ci-après.

En conséquence, dans le cas, général en pratique, où l'on ne connaît pas précisément la valeur d'émissivité de l'élément de scène, il est possible de déterminer la température de l'élément de scène de manière plus précise en utilisant les pixels 32 et 34 qu'en utilisant le pixel 3 de la figure 1B.

Un capteur du type du capteur 30 permet de déterminer la température de l'élément de scène sans connaître préalablement l'émissivité de cet élément de scène, ce qui n'est pas possible avec un capteur du type du capteur 1 de la figure 1.

De plus, l'utilisateur n'a pas besoin de fournir manuellement une valeur d'émissivité pour déterminer la température d'un élément de scène. La mesure de température est donc particulièrement pratique.

En outre, pour une scène comprenant des éléments ayant des émissivités différentes, l'utilisateur d'un capteur du type de celui des figures 1B et 1A ne peut pas en pratique fournir l'émissivité de chaque élément de scène. L'utilisateur est alors amené à fournir une valeur commune d'émissivité qui n'est pas adaptée à chaque élément de scène, ce qui rend les températures déterminées imprécises. Au contraire, dans un capteur du type du capteur 3, les différentes valeurs d'émissivité sont obtenues pour chaque élément de scène sans intervention manuelle de l'utilisateur, et les températures déterminées sont de ce fait particulièrement précises.

La figure 4 illustre un procédé mis en oeuvre par l'unité de traitement 38 pour obtenir la température $T_M$ d'un élément de scène à partir de deux valeurs mesurées V1 et V2 représentatives de valeurs de températures de membranes bolométriques de pixels 32 et 34 voisins.

Le procédé comprend à titre d'exemple la répétition d'itérations. Chaque itération prend pour point de départ un couple de valeurs estimées $E_E$ d'émissivité et $T_E$ de température et détermine un nouveau couple de valeurs estimées qui servira de point de départ pour l'itération suivante. A la première itération, les valeurs estimées $E_E$ et $T_E$ sont des valeurs initiales respectives Ei et Ti que l'on a choisies préalablement, par exemple respectivement une valeur Ei d'émissivité quelconque entre 0 et 1 et une valeur Ti de température proche de la température ambiante.

Chaque itération comprend une étape 62 (COMPUTE) de modélisation qui détermine des valeurs théoriques $V1_{TH}$ et $V2_{TH}$. La valeur théorique $V1_{TH}$ correspond à la valeur de température de membrane que l'on obtiendrait si l'élément de scène était à la température estimée $T_E$, compte tenu des propriétés d'absorption du pixel 32 (schématisées par la courbe 52 de la figure 3), d'après la loi de Planck pondérée par l'émissivité estimée $E_E$. On considère ici que l'émissivité $E_E$ est indépendante de la longueur d'onde. La valeur théorique $V2_{TH}$ est déterminée de manière similaire compte tenu des propriétés d'absorption du pixel 34 (schématisées par la courbe 54 de la figure 3). Pour déterminer les valeurs théoriques $V1_{TH}$ et $V2_{TH}$, on peut en outre tenir compte de l'absorption par des éléments se situant entre l'élément de scène et les pixels, par exemple l'atmosphère, ou tenir compte de fenêtres de transmission. Une telle fenêtre est couramment disposée au-dessus de la matrice de pixels, ou rétine, pour isoler la rétine de l'atmosphère. Le spectre de transmission d'une telle fenêtre est connu et peut donc facilement être pris en compte pour déterminer les valeurs théoriques.

A des étapes 64_1 et 64_2, les valeurs mesurées V1 et V2 sont comparées aux valeurs théoriques $V1_{TH}$ et $V2_{TH}$, ce qui fournit des valeurs de différence V1-$V1_{TH}$ et V2-$V2_{TH}$. Ces valeurs de différence sont utilisées à une étape 66 (ERR) pour déterminer une valeur d'erreur $\chi2$. A titre d'exemple, la valeur d'erreur $\chi2$ est une somme de carrés des valeurs de différences, par exemple une somme pondérée de la forme :

$$\chi2 \;=\; (^1/_{\sigma1}2)*(V1-V1_{TH})^2 \;+\; (^1/_{\sigma2}2)*(V2-V2_{TH})^2,$$

$\sigma1$ et $\sigma2$ représentant respectivement les incertitudes des valeurs V1 et V2 représentatives des températures des membranes. Chaque itération comprend alors une étape 68 (MIN) qui fournit des nouvelles valeurs estimées $E_E$ et $T_E$, en sorte de réduire la valeur d'erreur $\chi2$ itération après itération. A titre d'exemple, l'étape 68 est une étape d'un algorithme de minimisation d'une valeur dépendant de deux variables par évaluations successives de cette valeur à partir d'estimations successives des variables, telle qu'une méthode de gradient, de gradient conjugué, de simplexe, etc. Le procédé s'arrête lorsque la valeur de $\chi2$ est minimale. La valeur mesurée $T_M$ de la température de l'élément de scène est alors la valeur estimée $T_E$ à la dernière itération. Par ailleurs, la valeur estimée $E_E$ de l'émissivité à la dernière itération correspond à une valeur mesurée $E_M$ de l'émissivité de l'élément de scène.

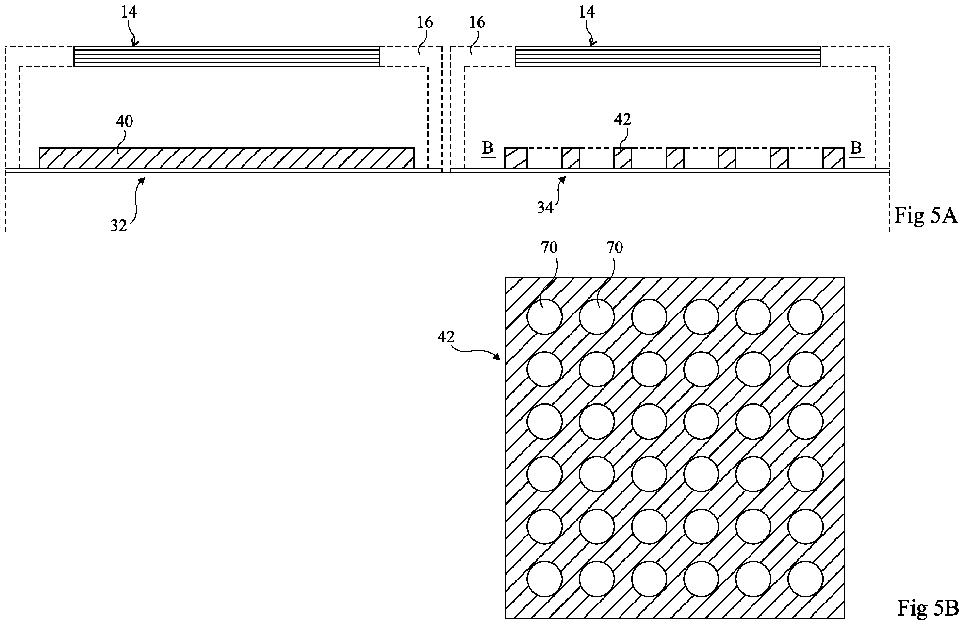

La figure 5A est une vue en coupe d'une variante de réalisation de deux pixels voisins 32 et 34, dans laquelle les couches diélectriques 40 du pixel 32 et 42 du pixel 34 sont en un même matériau et ont des mêmes épaisseurs. La figure 5B est une vue de dessus en coupe de la couche 42 selon le plan B-B de la figure 5A.

La couche 42 est interrompue sur toute son épaisseur par des ouvertures 70 disposées régulièrement. Les ouvertures 70 peuvent avoir des dimensions latérales inférieures aux longueurs d'onde des rayonnements infrarouges reçus, par exemple inférieures au tiers de la plus petite longueur d'onde de la plage de longueurs d'onde des rayonnements reçus. A titre d'exemple, le pas du motif en réseau dessiné par les ouvertures est de l'ordre de 1 à 3 $\mu$m. Les ouvertures représentées ont une forme circulaire, mais toute autre forme adaptée peut être utilisée. A titre de variante, les ouvertures voisines peuvent se rejoindre et la couche 42 est formée d'un ensemble de plots disjoints disposés régulièrement. La couche 42 présente ainsi un motif en réseau d'éléments définis par l'absence ou la présence du matériau de la couche 42, tels que des ouvertures ou des plots, répétés dans des directions parallèles au plan de la couche. L'indice de réfraction $n_{eff}$ de la couche 42 peut être estimé grossièrement par le produit de l'indice de réfraction $n_s$ du matériau de la couche 42 par le taux de remplissage $f$ de la couche 42. Une estimation plus précise de l'indice de réfraction de la couche 42 peut être calculée, par exemple selon l'équation suivante décrite dans l'article de M. E. Motamedi et al., "Antireflection surfaces in silicon using binary optics technology", publié en 1992 dans Applied Optics, 31(22) :

$$n_{eff} = \left[ \frac{[1 - f + f \times n_s^2] \times [f + (1-f) \times n_s^2] + n_s^2}{2 \times [f + (1-f) \times n_s^2]} \right]^{1/2}$$

L'indice de réfraction de la couche 42 est ainsi inférieur à celui de la couche 40. De plus, dans l'exemple représenté en figure 5A, si en partant du motif dessiné par les ouvertures dans la couche 42 on tourne ce motif d'un quart de tour, on retombe sur le motif de départ, en d'autres termes ce motif présente une symétrie d'ordre quatre. De ce fait l'indice de réfraction de la couche 42 ne dépend pas de la polarisation du rayonnement infrarouge. A titre de variante, le motif en réseau dessiné par des ouvertures ou des plots peut présenter une symétrie d'ordre supérieur, par exemple la symétrie d'ordre six d'un réseau hexagonal.

Des modes de réalisation particuliers ont été décrits. Diverses variantes et modifications apparaîtront à l'homme de l'art. En particulier, bien qu'un procédé particulier ait été décrit pour minimiser la valeur d'erreur $\chi 2$, tout autre procédé adapté à minimiser cette valeur peut être utilisé. Selon l'invention, après avoir mesuré les valeurs V1 et V2 représentatives de valeurs de températures de membranes bolométriques, on calcule la valeur d'erreur $\chi 2$ pour un ensemble de couples prédéfinis de valeurs estimées $T_E$ de température et $E_E$ d'émissivité d'élément de scène. Les valeurs déterminées de température et d'émissivité correspondent aux valeurs du couple prédéfini pour lequel la valeur $\chi 2$ est minimale. A titre d'autre exemple, la température d'élément de scène correspondant au minimum de cette valeur d'erreur peut être choisie parmi un ensemble de valeurs de températures déterminées préalablement en fonction d'un ensemble de valeurs V1, V2 de températures de membranes bolométriques. Ces valeurs déterminées préalablement sont alors mémorisées dans l'unité de traitement 38.

En outre, bien que, dans le procédé décrit ci-dessus, une valeur d'erreur particulière $\chi 2$ soit minimisée pour obtenir la valeur de température $T_M$, on peut minimiser toute valeur d'erreur représentative de différences entre d'une part des valeurs mesurées des températures de membranes de deux pixels voisins et d'autre part des valeurs théoriques correspondantes obtenues par modélisation.

De plus, bien que, dans le procédé décrit ci-dessus, une valeur de température soit déterminée d'une manière particulière, on peut utiliser tout autre procédé permettant de déterminer la température d'un élément de scène à partir de valeurs de température de deux membranes bolométriques de deux pixels de types différents en vis-à-vis de l'élément de scène. Les propriétés d'absorption des pixels peuvent aussi être modélisées par des expressions mathématiques permettant d'exprimer explicitement la température de l'élément de scène en fonction de celles des membranes.

En outre, on a décrit ci-dessus un exemple de procédé permettant d'obtenir une valeur de température et d'émissivité d'un élément de scène, dans l'hypothèse où cette émissivité ne dépend pas de la longueur d'onde. A titre de variante, on pourra, à partir d'une valeur de température de l'élément de scène connue préalablement, déterminer deux valeurs d'émissivité correspondant chacune à une plage de longueur d'onde absorbée par l'un des types de pixels 32 et 34. Pour cela, on pourra par exemple mettre en oeuvre le procédé décrit ci-dessus, dans lequel la valeur théorique $V1_{TH}$ correspond à la valeur de température de membrane que l'on obtiendrait si l'élément de scène était à la température connue préalablement, compte tenu des propriétés d'absorption du pixel 32, d'après la loi de Planck pondérée par une première valeur d'émissivité estimée dans la plage de longueurs d'onde du pixel 32, la valeur théorique $V2_{TH}$ étant déterminée de manière similaire pour une deuxième valeur d'émissivité estimée.

Bien que, dans les modes de réalisation décrits ci-dessus, un circuit de lecture soit prévu pour mesurer la température de membranes bolométriques, le circuit de lecture peut être prévu pour mesurer toute valeur représentative de la température des membranes bolométriques, par exemple une valeur de résistance.

Bien que, dans des modes de réalisation décrits ici, des pixels de deux types différents soient disposés en damier, ces pixels peuvent être disposés de toute autre manière permettant à chaque pixel d'un type d'être voisin d'un pixel d'un autre type. Par exemple, une disposition en lignes ou en colonnes alternées de pixels de chaque type conduit aux mêmes avantages. Selon une autre disposition particulière, les pixels d'un type sont plus nombreux, c'est-à-dire disposés de manière plus dense, que les pixels d'un autre type, les proportions des pixels étant par exemple respectivement de 75 % et 25 %. Bien que les modes de réalisation décrits comprennent une membrane bolométrique particulière, toute autre membrane bolométrique adaptée peut être utilisée, par exemple une membrane bolométrique ayant un nombre différent de couches diélectriques, ou une membrane dans laquelle la couche de mesure a été remplacée par d'autres structures de mesure de la température, par exemple des mesures des déformations et/ou des contraintes dues à la dilatation thermique.

De plus, bien que les modes de réalisation décrits comprennent un type de réflecteur particulier, on peut utiliser tout autre réflecteur permettant à la membrane bolométrique d'absorber, à plus de 50 % pour l'essentiel des longueurs d'onde concernées, les rayonnements émis par des éléments de scène.

Les modes de réalisation particuliers décrits comprennent des couches diélectriques 42 présentant des motifs en réseau et des couches diélectriques 40 pleines, c'est-à-dire dans chacune desquelles le matériau de la couche est présent au-dessous de l'intégralité de la membrane bolométrique. Diverses variantes sont possibles. On peut prévoir que chacune des couches diélectriques 40 et des couches diélectriques 42 présente un motif en réseau dont les éléments, par exemple des ouvertures ou des plots, sont répétés latéralement et ont des dimensions latérales inférieures à la longueur d'onde des rayonnements reçus, par exemple inférieures au tiers de la plus petite longueur d'onde de la plage de rayonnement concernée. Dans l'exemple de couches diélectriques 40 et 42 de matériaux identiques et d'épaisseurs identiques, l'essentiel alors est que les motifs des couches 40 et 42 soient différents.

Bien que, dans les modes de réalisation décrits, on ne considère que la plage de longueurs d'onde située entre 7 et 14 $\mu$m, il peut être préféré d'opérer dans une autre plage de longueurs d'onde, par exemple et typiquement en positionnant cette plage, c'est-à-dire le spectre de transmission d'une fenêtre de filtrage, autour du maximum d'émission selon la loi d'émission du corps noir à la température moyenne des scènes qu'il est question d'observer selon l'application particulière visée. L'homme de l'art saura adapter en conséquence le spectre de transmission de ladite fenêtre, ainsi que les pixels décrits en termes de dimensions, en particulier selon les relations décrites, dans l'espace entre membrane et réflecteur (distance D, épaisseurs et/ou indices de réfraction des couches diélectriques) pour produire les interférences sélectives de longueurs d'onde différentes inscrites dans ledit spectre ainsi sélectionné.

En outre, bien que les modes de réalisation de capteurs décrits soient destinés à capter des rayonnements infrarouges situés dans une plage qui s'étend entre 7 et 14 $\mu$m, d'autres modes de réalisation peuvent être destinés à capter des rayonnements infrarouges situés dans une plage qui s'étend entre 8 et 12,5 $\mu$m. Pour cela le capteur peut être disposé sous une fenêtre de transmission destinée à limiter le rayonnement reçu par le capteur à la plage comprise entre 8 et 12,5 $\mu$m. Les épaisseurs et les indices de réfraction des couches diélectriques 40 et 42 sont alors choisis pour que des interférences destructives apparaissent au niveau de la membrane 14 pour des longueurs d'onde proches respectivement de 8.5 $\mu$m et de 12 $\mu$m. A titre d'exemple, la couche diélectrique 40 a une épaisseur sensiblement égale à 0,9 $\mu$m et un indice de réfraction sensiblement égal à 3,5. A titre d'exemple, la couche diélectrique 42 a une épaisseur sensiblement égale à 0,9 $\mu$m et un indice de réfraction sensiblement égal à 2. Les autres dimensions du dispositif sont par exemple identiques aux dimensions correspondantes dans les dispositifs des figures 2A et 2B. Le capteur obtenu présente l'avantage d'exclure les rayonnements de longueurs d'onde supérieures à 12,5 $\mu$m, qui sont absorbés par l'atmosphère, et la mesure de température ou d'émissivité par le capteur est alors indépendante de la qualité de l'atmosphère et de la distance entre le capteur et l'élément de scène. La mesure de température et d'émissivité d'un tel capteur est alors particulièrement précise.

Des modes de réalisation décrits comprennent des pixels de seulement deux types différents absorbant à plus de 50 % les rayonnements situés dans deux plages différentes, ces deux plages s'étendant, dans un exemple décrit, sur plus de 3 $\mu$m de largeur. D'autres modes de réalisation différents sont possibles comprenant plus de deux types de pixel. A titre d'exemple, on prévoit chaque type de pixel pour qu'il absorbe à plus de 50 % les rayonnements dans une plage de longueurs d'onde différente de celle des autres types de pixel. Les étendues des plages de longueurs d'onde des différents types de pixels peuvent être sensiblement identiques. Ces plages de longueurs d'onde peuvent couvrir l'étendue de la plage de longueurs d'onde du rayonnement considéré. La température d'un élément de scène est alors déterminée à partir des plus de deux valeurs de températures de membranes bolométriques des pixels de types différents. Ceci permet de déterminer plus précisément la température et l'émissivité de l'élément de scène, et de déterminer plus précisément la température d'éléments de scène dont l'émissivité varie en fonction de la longueur d'onde.

A titre d'exemple, des couples de pixels 32 et 34 du type de ceux de la figure 2B sont dispersés de manière régulière dans un ensemble de pixels, ou rétine, comprenant des pixels 3 du type de celui de la figure 1B. L'unité de traitement 38 produit une première image thermique à partir des pixels 3. L'unité de traitement 38 superpose à cette première image une deuxième image contenant des informations de température et d'émissivité déterminées à partir des couples de pixels. Du fait que les dimensions latérales de chaque pixel 3 sont plus faibles que celles d'un couple de pixels, la première image peut avoir une résolution élevée. L'image obtenue contient des informations de température particulièrement précises et a une résolution élevée.

## Revendications

1. Capteur d'image infrarouge, comprenant :

- sur un support (10), une pluralité de premiers pixels (32) et une pluralité de deuxièmes pixels (34) destinés à capter un rayonnement infrarouge émis par un élément d'une scène, chaque pixel comprenant une membrane bolométrique (14) suspendue au-dessus d'un réflecteur (12) recouvrant le support, le réflecteur de chaque premier pixel étant recouvert d'une première couche diélectrique (40), et le réflecteur de chaque deuxième pixel étant recouvert d'une deuxième couche diélectrique (42) différente de la première couche diélectrique par ses propriétés optiques ;
- un circuit de lecture (36) de premières valeurs (V1, V2) représentatives des températures des membranes bolométriques (14) de premier et deuxième pixels voisins ; et
- une unité de traitement (38) adaptée à déterminer l'émissivité de l'élément de la scène à partir des premières valeurs (V1, V2), l'unité de traitement étant configurée pour produire des valeurs estimées de température ($T_i$, $T_E$) et d'émissivité ($E_i$, $E_E$) correspondant à un minimum d'une valeur d'erreur représentative de différences, les différences comprenant :

une première différence entre la première valeur (V1) lue du premier pixel et une deuxième valeur ($V1_{TH}$) représentative de la température qu'aurait la membrane bolométrique du premier pixel d'après un modèle théorique si la température et l'émissivité de l'élément de scène avaient les valeurs estimées ; et

une deuxième différence entre la première valeur (V2) lue du deuxième pixel et une autre deuxième valeur (V2$_{TH}$) représentative de la température qu'aurait la membrane bolométrique du deuxième pixel d'après le modèle théorique si la température et l'émissivité de l'élément de scène avaient les valeurs estimées.

2. Capteur selon la revendication 1, dans lequel la valeur d'erreur est une somme pondérée de la forme

$$\chi^2 \; = \; (^1/_{\sigma 1}2) \star (V1-V1_{TH})^2 \; + \; (^1/_{\sigma 2}2) \star (V2-V2_{TH})^2,$$

où $\chi^2$ est la valeur d'erreur, V1 et V2 sont les premières valeurs lues du premier et du deuxième pixels respectivement, V1$_{TH}$ et V2$_{TH}$ sont les deuxièmes valeurs représentatives des températures qu'auraient les membranes bolométrique du premier pixel et du deuxième pixel respectivement d'après un modèle théorique si la température et l'émissivité de l'élément de scène avaient les valeurs estimées, et $\sigma 1$ et $\sigma 2$ sont les incertitudes des valeurs V1 et V2 respectivement.

3. Capteur selon l'une quelconque des revendications 1 à 2, dans lequel l'unité de traitement (38) est configurée pour :

   a) définir un couple initial des valeurs estimées de température (Ti) et d'émissivité (Ei) ;
   b) calculer les deuxièmes valeurs respectives (V1$_{TH}$, V2$_{TH}$) sur la base des valeurs estimées ;
   c) calculer les différences entre les premières valeurs respectives (V1, V2) et les deuxièmes valeurs correspondantes ;
   d) produire des nouvelles valeurs estimées de température (T$_E$) et d'émissivité (E$_E$) sur la base desdites différences ; et
   e) répéter les étapes b), c) et d) sur la base des nouvelles valeurs estimées de façon à réduire lesdites différences.

4. Capteur selon l'une quelconque des revendications 1 à 3, dans lequel la différence de propriété optique résulte d'au moins une caractéristique dans la liste suivante :

   les première (40) et deuxième (42) couches diélectriques ont des épaisseurs différentes ;
   les première (40) et deuxième (42) couches diélectriques sont en des matériaux d'indices de réfraction différents ;
   la première couche (42) présente un motif en réseau et la deuxième couche (40) est pleine ; et
   les première (40) et deuxième (42) couches présentent des motifs en réseaux différents dans la première couche et dans la deuxième couche.

5. Capteur selon l'une quelconque des revendications 1 à 4, comprenant une matrice de couples de pixels de l'un des premiers pixels (32) et de l'un des deuxièmes pixels (34).

6. Capteur selon l'une quelconque des revendications 1 à 5, dans lequel les membranes bolométriques (14) de tous lesdits pixels sont structurellement identiques et les réflecteurs (12) de tous lesdits pixels sont structurellement identiques.

7. Capteur selon l'une quelconque des revendications 1 à 6, dans lequel les premiers (32) et deuxièmes (34) pixels sont disposés en damier.

8. Capteur selon l'une quelconque des revendications 1 à 7, destiné à capter des rayonnements dont les longueurs d'onde sont situées dans une plage de longueurs d'onde, la distance dans chaque pixel entre la membrane et ladite couche diélectrique étant égale au quart d'une longueur d'onde située dans une partie centrale de ladite plage.

9. Capteur selon la revendication 8, dans lequel ladite plage s'étend entre 7 et 14 um et ladite distance est comprise entre 2 et 3 um.

10. Capteur selon la revendication 8 ou 9, dans lequel, pour la première couche diélectrique, le produit de l'épaisseur par l'indice de réfraction est égal au quart d'une première longueur d'onde, et, pour la deuxième couche diélectrique, le produit de l'épaisseur par l'indice de réfraction est égal au quart d'une deuxième longueur d'onde, les première et deuxième longueurs d'onde étant situées dans ladite plage et étant différentes l'une de l'autre.

11. Capteur selon l'une quelconque des revendications 8 à 10, dans lequel les première (40) et deuxième (42) couches diélectriques sont en un matériau identique et ont une même épaisseur, la distance séparant la membrane bolométrique (14) de la couche diélectrique (40, 42) étant identique dans les premier et deuxième pixels, chaque deuxième couche diélectrique présentant un motif en réseau formé d'éléments ayant, dans des directions parallèles au plan de la couche, des dimensions inférieures au tiers de la plus petite longueur d'onde de ladite plage.

**12.** Capteur selon la revendication 11, dans lequel les première (40) et deuxième (42) couches diélectriques sont en silicium amorphe.

**13.** Capteur selon l'une quelconque des revendications 1 à 12, comprenant en outre une pluralité de troisièmes pixels (3) destinés à capter un rayonnement infrarouge émis par la scène extérieure, chaque troisième pixel comprenant une membrane bolométrique suspendue au-dessus d'un réflecteur recouvrant le support, le réflecteur n'étant pas recouvert d'une couche diélectrique.

**Patentansprüche**

**1.** Ein Infrarot-Bildsensor, der Folgendes aufweist:

- auf einem Träger (10) eine Vielzahl von ersten Pixeln (32) und eine Vielzahl von zweiten Pixeln (34), die dazu bestimmt sind, eine von einem Element einer Szene emittierte Infrarotstrahlung zu detektieren, wobei jedes Pixel eine bolometrische Membran (14) aufweist, die über einem den Träger bedeckenden Reflektor (12) aufgehängt ist, wobei der Reflektor jedes ersten Pixels mit einer ersten dielektrischen Schicht (40) bedeckt ist und der Reflektor jedes zweiten Pixels mit einer zweiten dielektrischen Schicht (42) bedeckt ist, die sich von der ersten dielektrischen Schicht durch ihre optischen Eigenschaften unterscheidet;
- eine Leseschaltung (36) zum Auslesen erster Werte (V1, V2), die die Temperaturen der bolometrischen Membranen (14) von ersten und zweiten benachbarten Pixeln darstellen; und
- eine Verarbeitungseinheit (38), die geeignet ist, die Emissivität des Szenenelements auf der Grundlage der ersten Werte (V1, V2) zu bestimmen, wobei die Verarbeitungseinheit konfiguriert ist zum Erzeugen geschätzter Temperatur-(Ti, $T_E$) und Emissivitätswerte (Ei, $E_E$), die einem Minimum eines Fehlerwerts entsprechen, der für Differenzen repräsentativ ist, wobei die Differenzen Folgendes aufweisen:

eine erste Differenz zwischen dem ersten Wert (V1), der aus dem ersten Pixel ausgelesen wurde, und einem zweiten Wert ($V1_{TH}$), der für die Temperatur repräsentativ ist, die die bolometrische Membran des ersten Pixels gemäß einem theoretischen Modell aufweisen würde, wenn die Temperatur und das Emissionsvermögen des Szenenelements die geschätzten Werte hätten; und
eine zweite Differenz zwischen dem vom zweiten Pixel abgelesenen ersten Wert (V2) und einem weiteren zweiten Wert ($V2_{TH}$), der für die Temperatur repräsentativ ist, die die bolometrische Membran des zweiten Pixels gemäß einem theoretischen Modell aufweisen würde, wenn die Temperatur und das Emissionsvermögen des Szenenelements den geschätzten Wert hätten.

**2.** Sensor nach Anspruch 1, wobei der Fehlerwert eine gewichtete Summe der folgenden Form ist

$$\chi2 = (^1/_{\sigma1}2) * (V1-V1_{TH})^2 + (^1/_{\sigma2}2) * (V2-V2_{TH})^2,$$

wobei χ2 der Fehlerwert ist, V1 und V2 die ersten Werte sind, die vom ersten bzw. zweiten Pixel abgelesen werden, $V1_{TH}$ und $V2_{TH}$ die zweiten Werte sind, die die Temperaturen darstellen, die die bolometrische Membran des ersten Pixels bzw. des zweiten Pixels gemäß einem theoretischen Modell haben würde, wenn die Temperatur und die Emissivität des Szenenelements die geschätzten Werte hätten, und σ1 und σ1 die Unsicherheiten in den Werten V1 bzw. V2 sind.

**3.** Der Sensor nach einem der Ansprüche 1 bis 2, wobei die Verarbeitungseinheit (38) konfiguriert ist, zum:

a) Definieren eines Anfangspaars von geschätzten Temperatur- (Ti) und Emissivitätswerten (Ei);
b) Berechnen der jeweiligen zweiten Werte ($V1_{TH}$, $V2_{TH}$) basierend auf den geschätzten Werten;
c) Berechnen der Differenzen zwischen den jeweiligen ersten Werten (V1, V2) und den entsprechenden zweiten Werten;
d) Erzeugen neuer geschätzter Werte für die Temperatur ($T_E$) und die Emissivität ($E_E$) auf der Grundlage dieser Differenzen; und

e) Wiederholen der Schritte b), c) und d) auf der Grundlage der neuen geschätzten Werte, um die Differenzen zu verringern.

4. Sensor nach einem der Ansprüche 1 bis 3, wobei der Unterschied der optischen Eigenschaft aus mindestens einem Merkmal der folgenden Liste resultiert:

die erste (40) und die zweite (42) dielektrische Schicht haben unterschiedliche Dicken;
die erste (40) und die zweite (42) dielektrische Schicht sind aus Materialien mit unterschiedlichen Brechungsindizes hergestellt;
die erste Schicht (42) hat ein regelmäßiges Muster und die zweite Schicht (40) ist kontinuierlich; und
die erste (40) und die zweite (42) Schicht haben unterschiedliche regelmäßige Muster in der ersten Schicht und in der zweiten Schicht.

5. Sensor nach einem der Ansprüche 1 bis 4 aufweisend eine Anordnung von Pixelpaaren aus einem der ersten Pixel (32) und einem der zweiten Pixel (34).

6. Sensor nach einem der Ansprüche 1 bis 5, wobei die bolometrischen Membranen (14) aller Pixel strukturell identisch sind und die Reflektoren (12) aller Pixel strukturell identisch sind.

7. Sensor nach einem der Ansprüche 1 bis 6, wobei die ersten (32) und zweiten (34) Pixel in einem Schachbrettmuster angeordnet sind.

8. Sensor nach einem der Ansprüche 1 bis 7, der dazu bestimmt ist, Strahlungen mit Wellenlängen zu detektieren, die in einem Wellenlängenbereich liegen, wobei der Abstand in jedem Pixel zwischen der Membran und der dielektrischen Schicht gleich einem Viertel einer Wellenlänge ist, die in einem mittleren Teil des Bereichs liegt.

9. Sensor nach Anspruch 8, wobei sich der Bereich zwischen 7 und 14 $\mu$m erstreckt und der Abstand im Bereich von 2 bis 3 $\mu$m liegt.

10. Sensor nach Anspruch 8 oder 9, wobei für die erste dielektrische Schicht das Produkt aus der Dicke und dem Brechungsindex gleich einem Viertel einer ersten Wellenlänge ist und für die zweite dielektrische Schicht das Produkt aus der Dicke und dem Brechungsindex gleich einem Viertel einer zweiten Wellenlänge ist, wobei die erste und die zweite Wellenlänge innerhalb des Bereichs liegen und voneinander verschieden sind.

11. Sensor nach einem der Ansprüche 8 bis 10, **dadurch gekennzeichnet, dass** die erste (40) und die zweite (42) dielektrische Schicht aus einem identischen Material bestehen und die gleiche Dicke aufweisen, wobei der Abstand zwischen der bolometrischen Membran (14) und der dielektrischen Schicht (40, 42) im ersten und im zweiten Pixel identisch ist, wobei jede zweite dielektrische Schicht ein regelmäßiges Muster aufweist, das aus Elementen gebildet ist, die in zur Schichtebene parallelen Richtungen Abmessungen aufweisen, die kleiner als ein Drittel der kleinsten Wellenlänge des genannten Bereichs sind.

12. Sensor nach Anspruch 11, wobei die erste (40) und die zweite (42) dielektrische Schicht aus amorphem Silizium hergestellt sind.

13. Sensor nach einem der Ansprüche 1 bis 12, der ferner eine Vielzahl von dritten Pixeln (3) aufweist, die dazu bestimmt sind, eine von der äußeren Szene emittierte Infrarotstrahlung zu detektieren, wobei jedes dritte Pixel eine bolometrische Membran aufweist, die über einem den Träger bedeckenden Reflektor aufgehängt ist, wobei der Reflektor nicht mit einer dielektrischen Schicht bedeckt ist.

**Claims**

1. An infrared image sensor, comprising:

- on a support (10), a plurality of first pixels (32) and a plurality of second pixels (34) intended to detect an infrared radiation emitted by an element of a scene, each pixel comprising a bolometric membrane (14) suspended above a reflector (12) covering the support, the reflector of each first pixel being covered with a first dielectric layer (40), and the reflector of each second pixel being covered with a second dielectric layer (42) differing from the first dielectric layer by its optical properties;
- a read circuit (36) for reading out first values (V1, V2) representative of the temperatures of the bolometric membranes (14) of first and second neighboring pixels; and
- a processing unit (38) adapted to determine the emissivity of the scene element based on the first values (V1, V2), the processing unit being configured to generate estimated temperature (Ti, $T_E$) and emissivity (Ei, $E_E$) values corresponding to a minimum of an error value representative of differences, the differences comprising:

a first difference between the first value (V1) read from the first pixel and a second value ($V1_{TH}$) representative of the temperature that the bolometric membrane of the first pixel would have according to a theoretical model if the temperature and the emissivity of the scene element had the estimated values; and
a second difference between the first value (V2) read from the second pixel and a further second value ($V2_{TH}$) representative of the temperature that the bolometric membrane of the second pixel would have according to a theoretical model if the temperature and the emissivity of the scene element had the estimated value.

2. The sensor of claim 1, wherein the error value is a weighted sum of the form:

$$\chi^2 = (1/_{\sigma 1}^2) * (V1 - V1_{TH})^2 + (1/_{\sigma 2}^2) * (V2 - V2_{TH})^2,$$

where $\chi^2$ is the error value, V1 and V2 are the first values read from the first and second pixels respectively, $V1_{TH}$ and $V2_{TH}$ are the second values representative of the temperatures that the bolometric membrane of the first pixel and of the second pixel respectively would have according to a theoretical model if the temperature and the emissivity of the scene element had the estimated values, and $\sigma 1$ and $\sigma 1$ are the uncertainties in the values V1 and V2 respectively.

3. The sensor of any of claims 1 to 2, wherein the processing unit (38) is configured to:

a) define an initial pair of estimated temperature (Ti) and emissivity (Ei) values;
b) calculate the respective second values ($V1_{TH}$, $V2_{TH}$) based on the estimated values;
c) calculate the differences between the respective first values (V1, V2) and the corresponding second values;
d) generate new estimated temperature ($T_E$) and emissivity ($E_E$) values based on said differences; and
e) repeat steps b), c), and d) based on the new estimated values to decrease said differences.

4. The sensor of any of claims 1 to 3, wherein the optical property difference results from at least one feature from the following list:

the first (40) and second (42) dielectric layers have different thicknesses;
the first (40) and second (42) dielectric layers are made of materials having different refraction indexes;
the first layer (42) has a regular pattern and the second layer (40) is continuous; and
the first (40) and second (42) layers have different regular patterns in the first layer and in the second layer.

5. The sensor of any of claims 1 to 4, comprising an array of pairs of pixels of one of the first pixels (32) and of one of the second pixels (34).

6. The sensor of any of claims 1 to 5, wherein the bolometric membranes (14) of all of said pixels are structurally identical and the reflectors (12) of all of said pixels are structurally identical.

7. The sensor of any of claims 1 to 6, wherein the first (32) and second (34) pixels are arranged in a checkerboard layout.

8. The sensor of any of claims 1 to 7, intended to detect radiations having wavelengths located in a wavelength range, the distance in each pixel between the membrane and said dielectric layer being equal to one quarter of a wavelength located in a central portion of said range.

9. The sensor of claim 8, wherein said range extends between 7 and 14 $\mu$m and said distance is in the range from 2 to 3 $\mu$m.

10. The sensor of claim 8 or 9, wherein, for the first dielectric layer, the product of the thickness by the refraction index is equal to one quarter of a first wavelength and, for the second dielectric layer, the product of the thickness by the refraction index is equal to one quarter of a second wavelength, the first and second wavelength being within said range and being different from each other.

11. The sensor of any of claims 8 to 10, wherein the first (40) and second (42) dielectric layers are made of an identical material and have a same thickness, the distance separating the bolometric membrane (14) from the dielectric layer (40, 42) being identical in the first and second pixels, each second dielectric layer having a regular pattern formed of elements having, in directions parallel to the plane of the layer, dimensions smaller than one third of the smallest wavelength of said range.

12. The sensor of claim 11, wherein the first (40) and second (42) dielectric layers are made of amorphous silicon.

13. The sensor of any of claims 1 to 12, further comprising a plurality of third pixels (3) intended to detect an infrared radiation emitted by the outer scene, each third pixel comprising a bolometric membrane suspended above a reflector covering the support, where the reflector is not covered with a dielectric layer.

Fig 1A

Fig 1B

Fig 2A

Fig 2B

Fig 3

Fig 4

Fig 5A

Fig 5B

EP 3 551 976 B1

18

## RÉFÉRENCES CITÉES DANS LA DESCRIPTION

**Documents brevets cités dans la description**

- JP 11326039 A

- US 5868496 A

**Littérature non-brevet citée dans la description**

- **M. E. MOTAMEDI et al.** Antireflection surfaces in silicon using binary optics technology. *Applied Optics,* 1992, vol. 31 (22